(19) Europäisches Patentamt
European Patent Office
Office européen des brevets

(11) EP 2 813 464 B1

(12) EUROPEAN PATENT SPECIFICATION

(45) Date of publication and mention
of the grant of the patent:
**08.08.2018 Bulletin 2018/32**

(51) Int Cl.:
**B81B 7/00** (2006.01)      **H01L 23/26** (2006.01)

(21) Application number: **13290135.6**

(22) Date of filing: **12.06.2013**

(54) **Device with getter material**

Vorrichtung mit Getter-Material

Dispositif avec un matériau getter

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**17.12.2014 Bulletin 2014/51**

(73) Proprietor: **Tronic's Microsystems**
**38920 Crolles (FR)**

(72) Inventors:
• **Collet, Joël**
**38410 Saint Martin d'Uriage (FR)**

• **Leclerc, Jacques**
**26000 Valence (FR)**

(74) Representative: **Cabinet Laurent & Charras**
**Le Contemporain**
**50 Chemin de la Bruyère**
**69574 Dardilly Cedex (FR)**

(56) References cited:
**EP-A1- 2 546 187      DE-A1- 10 236 855**
**US-A1- 2004 061 207      US-A1- 2007 262 428**
**US-A1- 2010 001 361      US-A1- 2013 089 955**

## Description

### Technical Field

The invention relates to a device comprising

a) a support structure with a support area,
b) a group of elements of at least one getter material provided on said support area within a group perimeter, wherein said group of getter material elements provides a total exposure surface for absorbing gas molecules from a space above said support structure,
c) wherein the total exposure surface has a three-dimensional shape.

The invention also refers to a method for manufacturing such a device.

### Background Art

The MEMS technology (MEMS = microelectromechanical system) is used for many types of sensors such as rotation detection, acceleration detection, pressure measurement, as well as for different types of actuators. The MEMS device uses a mobile structure inside an evacuated and sealed cavity. It is important that the vacuum in the cavity be maintained for many years. There are also other technologies and devices that use sealed housings with getter material inside the housing.

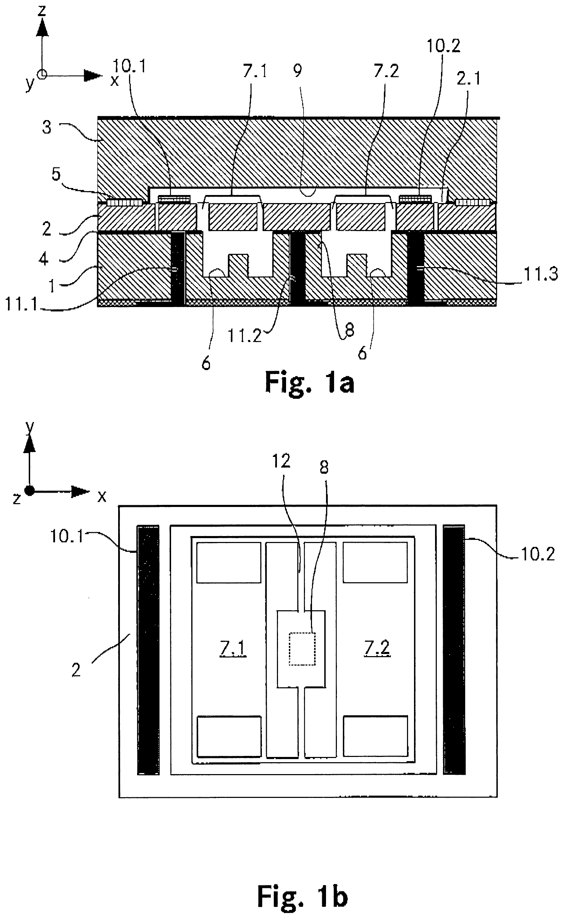

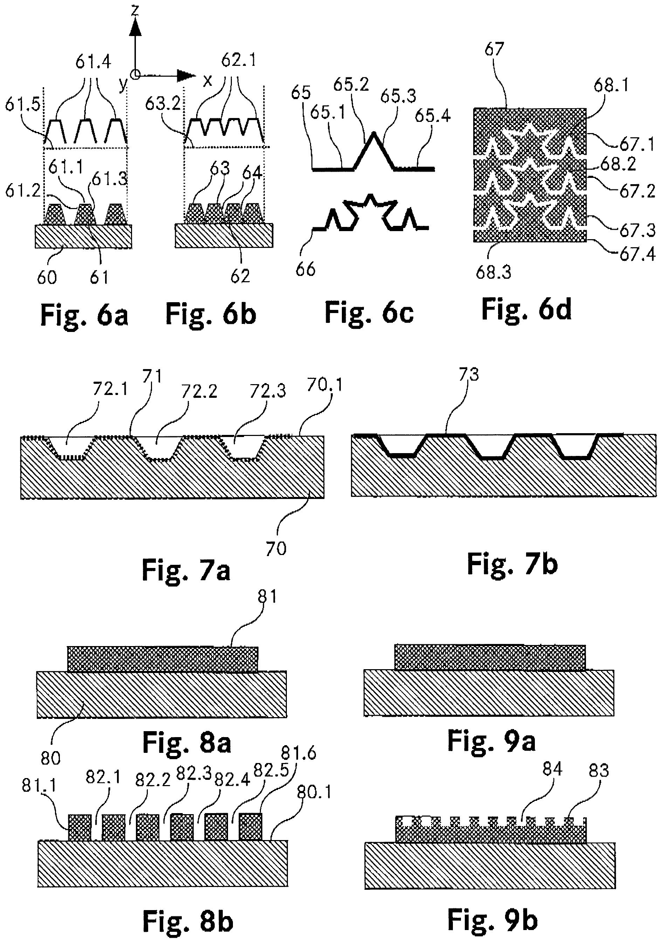

US 6,929,974 B1 (Motorola) discloses a microdevice having a hermetically sealed cavity to house a microstructure between the substrate and the cap. The microstructure may be a gyroscope that is mounted on protrusions of the substrate (Fig. 1B of US 6,979, 974 B1). Alternatively the microstructure may be an element mounted on the rim of a recess of the substrate (Fig. 6B). The cap has one recess for each microstruture and in each recess there is an embedded crystalline silicon getter layer. The getter layer helps maintain the vacuum within the cavity. In one embodiment, the microdevice comprises a substrate, a cap and an isolation layer. A cavity is at least partially defined by a recess in the cap. There is also a microdevice comprising a substrate (130), a cap (150) and a plurality of via covers.

US 2010/0025845 A1 (Fraunhofer Institut) discloses a multiple element component which is to be subsequently individualized by forming elements containing active structures. The component comprises a flat substrate and also a flat cap structure which are bound to each other such that they surround at least one first and one second cavity per component which are sealed against each other and towards the outside. The first of the two cavities is provided with getter material and due to the getter material has a different internal pressure than the second cavity.

EP 1 412 550 B1 (Saes Getters) discloses a method for producing MEMS devices with getter integrated in the wafer level package. The starting point is the problem when using known PVD or CVD or sputtering steps for producing localized deposits of gas absorbing materials in the course of known solid state production steps. Such processes generate localized deposition by resin deposition, local sensitization of resin, deposition of gas absorbing material (getter) and subsequent removal of sensitized resin and of gas absorbing material, so that the gas absorption material is left in the area from which the resin had been removed.

There are several proposals for shaping the surface of a support for a getter layer. According to the particular production process of US 2013/089955 A1 the getter material has to be inserted through a narrow opening in the cap of the device. In order to increase the getter material surface that is in contact with the atmosphere, the substrate may be provided with a relief (embossment or cavity 124) and the getter material is deposited in such a way as to cover the walls of the relief. In US 2007/262428 A1 the getter material is also deposited on a surface relief. US 2004/061207 A1 (Motorola) proposes a getter structure that has a reduced thermal activation energy and a large gas absorption area. The getter layer is not directly on the substrate but is supported by small support or pillars. The surface of the getter layer that is directed to the space enclosed inside the device is flat. US 2004/061207 A1 (Motorola) describes a microdevice having a single crystalline silicon getter for maintaining a vacuum within a cavity surrounding the device's microstructure. The getter is formed by electrochemically etching a silicon wafer into a porous structure. The single crystalline silicon getter may be modified by corrugating the silicon getter layer.
EP 2 546 187 A1 (CEA) proposes a getter structure that can be implemented with a standard process and that may have a variable activation temperature and an adjustable pumping power. The getter may be a layer with variable thickness. Also, the getter may be present in several separate elements with varying thickness.

The lifetime of a device that uses a sealed space mainly depends on the measures implemented to maintain the vacuum (or the inert gas atmosphere). One possible measure is to provide sufficient getter material in the sealed space. However, the surface area for depositing getter layers may be very limited, for instance because a large part of the surface of the sealed space is dedicated to other uses.

### Summary of the invention

It is an object of the invention to create a device belonging to the technical field initially mentioned that enables improved control of the vacuum (or of an inert gas atmosphere) in a sealed space. It is a specific object of the invention to increase the effectiveness of a getter layer.

The solution of the invention is specified by the features of claim 1.

According to the invention there is a support structure with a support area. The support structure is for instance a silicon wafer or a silicon chip or a housing base for a sealed package. The material of the support structure is not essential for the invention and depends on the intended use of the device. Ceramic or insulator materials may also be used. The support structure may also consist of several layers such as a semiconductor on insulator (SOI) or of a multi-layer cermet.

A certain part of the support structure carries getter material. This part is called the support area for getter material. The getter material may be present in the form of one contiguous layer or block or in the form of several layers or blocks that are spaced apart from each other. One contiguous layer or block is called a getter material element. Therefore, according to the invention there are one or more getter material elements on the support area (i.e. a group of at least one getter material elements). It is to be noted, that there may be more than one support areas on the support that are separated from each other by areas without getter material. Each of the separate support areas may comprise one or two or more getter material elements. A group of getter material elements provides a total exposure surface for absorbing gas molecules from a space above said support structure. The total exposure surface may consist of one or two or more getter material element surfaces.

It is pointed out that the total exposure surface has a three-dimensional shape. That means that the total exposure surface is not completely flat but has a substantial part that is inclined with respect to the z direction of the support element. (The z-direction at a specific point of the support structure is the direction that is substantially orthogonal to the surface. Normally, the support structure is plate-like and the plane of the plate extends in x-and y-direction, while the z-direction is orthogonal to the plane of the plate.)

According to the invention, the three-dimensional shape of the exposure surface is such that a ratio between the exposure surface area and a flat area delimited by the group perimeter is at least 120%.

That is, the exposure surface is not everywhere flat but shows an appropriate amount of "folding".

In the framework of the invention, the term "exposure surface" refers to the geometric surface of the getter material body at a micrometer level or above. However, the term "exposure surface" does not refer to the surface measured at a nanometer level, i. e. it does not include pores of a diameter below 100 nanometer in the getter material element. The getter material may well be porous. The invention also increases the efficiency of porous getter material elements.

It is one of the advantages of the invention that the gas absorption capability can be increased without changing the type of getter material or without increasing the used area of the support. This means, that it is quite easy to apply the invention to different types of existing supports and e.g. to existing microelectronic devices (such as MEMS-sensors). It is not necessary to change the getter material or to modify the sensor or actuator design for increasing the absorption capacity of the getter material.

Higher ratio:

In a preferred embodiment the ratio between the exposure surface area and the support surface area is at least 150%. The advantage of this increased lower limit is that the effectiveness of the getter in the sealed space is strongly increased and so is the lifetime of the sealed device. At the same time, the folding (i.e. geometric shape) of the exposure surface is not yet very complicated.

A ratio of less than 150%, for instance a ratio between 130% and 150% is still quite interesting, because the grade of folding of the three-dimensional total exposure surface is lower.

Several getter material elements:

According to a specific embodiment of the invention said group of getter material elements comprises at least two getter material elements at a mutual distance of not more than twice the maximum thickness of a first of said getter material elements. Preferably, the number of getter material elements is at least 10.

The distance between adjacent getter material elements within the group may be greater than twice the maximum thickness of any one of the of said getter material elements.

Two-dimensional array:

The getter material elements may be arranged in a two-dimensional array. So there are many (at least two) rows and many (at least two) columns of elements. They may be arranged in a regular way (i.e. in a grid-like geometry). According to a specific embodiment, all getter material elements have the same thickness. In such a case it may be advantageous to have at least 100 getter material elements in a two-dimensional array of e.g. 10 x 10 elements. It is evident that the two-dimensional array may be implemented in many other ways. The number of elements may of course be less or more than 100. Furthermore, it is also possible to have getter material elements of different thickness in the same group of getter material elements.

However, the invention can also be realized by means of a one-dimensional array of elements, e.g. an array of long and narrow stripes of getter material arranged side-by-side.

While it is simple to design an array of identical elements, the invention also covers groups of non-identically shaped elements or even stochastically distributed elements in the support surface area.

Layer with thickness-variation:

According to a specific embodiment of the invention, at least one of the getter material elements is a layer extending in x and y direction and having a thickness that varies between a maximum value ($d_{max}$) and a minimum value ($d_{min}$). This means, that the top surface of the getter material element is not purely parallel to the support surface. There may be partial areas, where the support surface and the top surface (exposure surface) are parallel, but there are also other partial areas, where there is a step or an inclination of the exposure surface.

Alternatively, it is also feasible that all getter material elements have a constant thickness (e.g. due to a rectangular cross-section). The ratio between the total exposure surface area and the support surface area that is covered by the getter material element is increased by reducing the lateral extension of the getter material elements and by reducing the distance between neighbouring elements.

Preferably, the thickness varies in x and in y direction periodically. That means that there is a regular array of protrusions and recesses in the exposure surface of the getter material element. This type of three-dimensional "folding" of the exposure surface results in a substantial increase of the ratio between the exposure surface and the support surface that is used fro the group of getter material elements. Of course, it is also possible to have periodic thickness variation in only one dimension.

Fractal trenches:

According to the invention it is also possible to provide a getter material layer with one or more trenches that have the shape of a fractal curve. If the depth of the trenches is the same as the thickness of the getter material layer, the separation by the fractal trenches leads to a number of getter material elements that are separated from each other by the fractal trenches. If the depth of the trenches is less than the thickness of the getter material layer, the result is a getter material element that has a varying thickness. To put it in other words: the three-dimensional shape of the exposure surface of the at least one getter material element comprises one or more trenches that have the shape of a fractal curve. The trenches preferably have a u-shaped or v-shaped cross section.

Geometric dimensions of getter material:

The invention is preferably used for getter material elements that have a thickness in the range of not more than 3 microns. It is even more advantageous to have a getter material element thickness of not more than 1.5 microns. A smaller thickness of the getter material is easier to deposit. The maximal thickness of the getter material element is preferably in the range of 1 - 1.5 micron. However, the thickness may also be less than 1 micron (e.g. in the range of ¾ - 1 micron.

According to a specific embodiment at least one getter material element has a width to thickness ratio of not more than 20. Preferably the ratio is at most 10. These two upper limits of the ratio apply particularly to getter material elements that have the shape of a stripe (which may be defined as a geometric form that has a length that is several times i.e. > 2 times more than the width).

In another specific embodiment of the invention, the distance in x or y direction between a first spot with maximum thickness and a second spot with minimum thickness is not more than 5 times the maximum thickness. The first and the second spot are on the same getter material layer.

The exposure surface may have trenches and protrusions, the thickness of the layer in the trenches corresponding to the minimum thickness and in the protrusions to the maximum thickness. The getter material element may have only recesses and no protrusions.

Support surface:

Preferably the support surface is flat within the perimeter of the support area. This has the advantage that the substrate does not have to be pre-processed in a particular way prior to depositing the getter material. However, the support surface may also be corrugated. The support surface area may also consist of several sections having different levels.

In most cases the device of the invention comprises a cap structure sealed to the support structure, wherein the group of getter material elements is arranged in a sealed space between the support structure and the cap structure. For a wafer level package, the support structure is a base wafer and the cap structure is a cap wafer. The cap wafer may have a plurality of recesses that match recesses in the base wafer. Therefore, two mating recesses define a sealed space when the two wafers are bonded together. The sealed space may be evacuated or filled with an inert gas.

Inside the sealed space there may be a mobile structure, for instance a tuning-fork sensor structure, a proof mass structure, a micro-actuator structure or another structure. The getter material elements may also be provided on a mobile structure if they are small. While a continuous layer covering the mobile structure might have an undesired influence on the stiffness of the mobile structure, the group of at least two, relatively small getter material elements does not. It is preferable to separate the getter material that is deposited on the mobile structure, into at least 10 elements. The getter layer segmentation minimizes the bi-metallic strip effect due to thermal effects.

The invention also refers to a process for manufacturing a device which has one or more getter material elements on a support surface of a support structure. The process comprises the following steps:

First, a group of at least one getter material elements is provided on the support structure within a support surface area. The getter material may be provided by a deposition process (such as an evaporation method) in combination with appropriate masking method.

Second, said group of getter material elements is provided in such a way that the three-dimensional shape of the exposure surface is such that a ratio between the exposure surface area and a flat area delimited by the group perimeter is at least 120%. This step may comprise selectively removing parts from the top surface of the getter material element so as to provide recesses. The step may also comprise selectively or repeatedly depositing getter material so as to generate a double layer or multi-layer structure.

According to a specific embodiment of the process, the getter material is deposited on the support surface in the form of a layer with constant thickness. This may lead to a contiguous layer that may be provided afterwards with recesses or that may be separated afterwards into at least two separate getter material elements. It is also possible to provide a number of separate layers in such a way that the ratio "exposure surface"/"flat area delimited by the group perimeter" is at least 120%. That means that the layer and wherein afterwards getter material is selectively removed to generate the three-dimensional exposure surface.

Instead of using a subtractive process as mentioned above (namely, providing a layer and then removing or "subtracting" certain parts of the layer) it is also possible to use an additive process. Such a process uses several steps of deposition to generate the final getter material structure. For instance by first depositing a continuous first layer of getter material and then selectively depositing parts of a second layer of getter material.

Other advantageous embodiments and combinations of features are evident from the detailed description below and the totality of the claims.

**Brief description of the drawings**

The drawings used to explain the embodiments show:

Fig. 1a, b a cross-section and a top plan view of a device with getter material;

Fig. 2a, b, c a schematic representation of a group of getter material elements according to the invention;

Fig. 3a, b, c a getter material element with a top surface with trenches;

Fig. 4a, b a two-dimensional array of getter material elements;

Fig. 5a, b explanation of the flat area delimited by the group perimeter;

Fig. 6a, b schematic cross-sections of different structures of getter material elements,

Fig. 6c, schematic diagram illustrating a fractal curve (Koch curve),

Fig. 6d schematic top plan view of a getter material layer with fractal trench,

Fig. 7a, b schematic representation of different embodiments with a support surface having a structure in z-direction;

Fig. 8a, b Process for manufacturing of a getter material structure,

Fig. 9a, b Process for manufacturing of a getter material structure,

Fig. 10a, b mathematical representation of the spaced for allowable values of the parameters for two embodiments.

In the figures, the same components are carrying the same reference symbols.

**Preferred embodiments**

Fig. 1a shows a schematic cross-section of a MEMS device with getter material in the inner space. The device substantially consists of three layers, namely a base layer 1 (e.g. a silicon substrate), an intermediate MEMS layer 2 (e.g. a silicon on insulator layer) and a cap layer 3 (e.g. a silicon substrate). Between the MEMS layer 2 and the base layer 1 there is an insulator layer 4. The cap layer 3 is sealed to the MEMS layer 2 by means of a sealing layer 5.

The base layer 1 has a cavity 6 in which there is an anchor post 8. The cavity 6 is below mobile masses 7.1, 7.2, which are machined into the MEMS layer 2. The mobile masses 7.1, 7.2 are supported by the anchor post 8. A second cavity 9 in the cap layer 3 is above the mobile masses 7.1, 7.2. Therefore, the mobile masses 7.1, 7.2 may move or vibrate in the x-y plane or in z-direction, whatever is required by the circumstances (e.g. for an acceleration sensor or a rotation rate sensor).

The mobile mass 7.1, 7.2 is electrically connected to the outside by an electrical conductor path 11.2 penetrating the base layer 1. There are additional electrical conductor paths 11.1, 11.3 for contacting activation electrodes or sensor electrodes (not shown).

On top of the MEMS layer 2 and at the outskirt of the cavity 9 there are two areas 10.1, 10.2 of getter material. While these areas 10.1, 10.2 may seem small for maintaining the desired vacuum in the sealed space (which is defined by cavities 6 and 9), they are satisfactory due to the increased effect of the structure of the getter material according to the invention.

Fig. 1b shows a schematic top plan view of the MEMS layer 2. The shape of the mobile masses 7.1, 7.2 and of the suspension elements 12 are just for illustration and do not have any relevance for the invention.

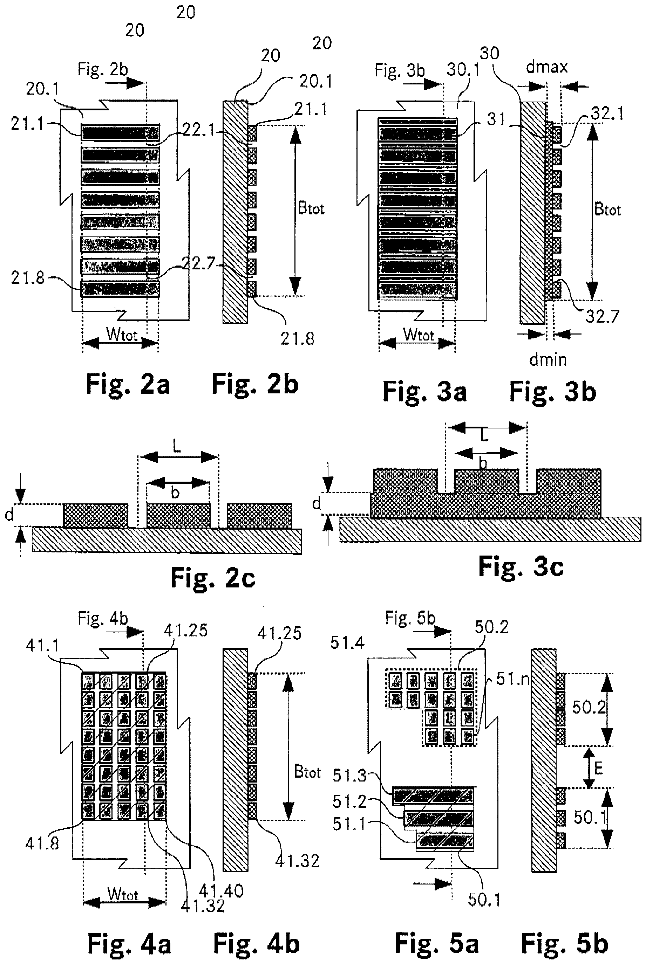

Fig. 2a-c show a first preferred embodiment of the structure of the getter material. The support structure 20 has a surface area 20.1, that is provided for the getter material, contains a plurality of stripe-shaped getter material elements 21.1, ..., 21.8. While Fig. 2a, b show eight getter material elements 21.1, ..., 21.8, there may be many more, e.g. twenty or fifty or even more than hundred. Between the getter material elements there are narrow gaps or trenches 22.1, ..., 22.7, which increase the effect of the getter. According to the invention, there is substantially more getter material surface available for absorbing gas molecules than according to the prior art, which only teaches continuous layers or big junks of getter with mainly flat absorption surface.

The group of getter material elements 21.1, ..., 21.8 occupies on the substrate 20 a surface area that has the perimeter of a rectangle with a total width Wtot and a total length Btot. The flat area Aflat defined by the group perimeter is:

$$A_{flat} = B_{tot} \times W_{tot}$$

Fig. 2c shows the geometry of a so called "one-dimensional structure" of the getter material. The structure has a periodic length L (in x-direction). Each getter material element 22.2 has a width b < L and a thickness d. If the number n of periods L is very large and if the extension in y-direction is very large compared to L, the increase of the effective getter material surface relative to the support surface per period is according to the invention approximately:

$$\frac{b}{L} \geq 1.2 - 2\frac{d}{L}$$

It is to be remembered that according to the invention the ratio between the exposure surface area and a flat area delimited by the group perimeter is at least 120%. This approximation is valid if fringe effects (at the outskirt of the getter material area) are disregarded.

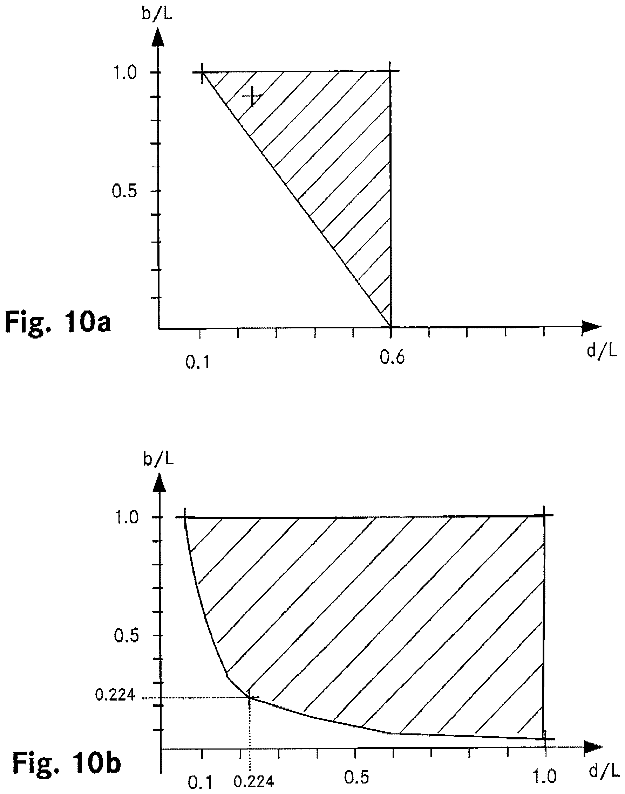

Fig. 10a shows the parameter range (hatched triangular area) for b/L and d/L. The width b/L of a getter material element is e.g. 0.9, and the thickness d/L is e.g. 0.25. If the getter material element as a nominal thickness of 1 micron, the periodic length L may be 4 micron, the width b may be 0.36 micron.

Fig. 3a, b show an alternative embodiment. On the surface 30.1 of a support structure 30 there is one single getter material element 31 with an increased exposure surface. The top surface of the getter material element 31 has a number of trenches 31.1, ..., 31.7. While Fig. 3b may suggest that the getter material element is made up of a continuous base layer and of a great number of stripe-like elements on top of the base layer, this really may be the case. However, the trenches may also result from machining the top surface of a thick getter material layer to produce trenches in the top surface.

The present embodiment is also called "one-dimensional" because the trenches extend in y-direction and because there are no trenches extending in x-direction.

According to Fig. 3a, b the group of getter material elements consists of one single getter material element 31 that occupies on the substrate 30 a surface area that has the perimeter of a rectangle with a total width Wtot and a total length Btot. The flat area Aflat defined by the group perimeter is:

$$A_{flat} = B_{tot} \times W_{tot}$$

If the periodic length L is small compared to the overall length Btot of the getter material area (e.g. overall length Btot > 10 x L), the increase of the getter material surface to the support surface is according to the invention approximately

$$\frac{L + 2d}{L} \geq 1.2$$

$$\frac{d}{L} \geq 0.1$$

The formula is based on the requirement of the invention that the ratio between the exposure surface area and a flat area delimited by the group perimeter is at least 120%. This means: The depth of the trenches has to be at least 10% of the periodic length L. Preferably, the depth d is at least L/4, because this leads to an increase of efficiency of at least 50%. For example the geometric dimensions may be as follows: Maximum thickness of the getter material dmax = 1.5 micron, trench depth d = 1 micron, periodic length L = 4 micron.

The thickness of the getter material element 31 varies between a maximum thickness dmax and a minimum thickness dmin. The transition from a surface point at the maximum thickness to a surface point at the minimum thickness may be a step as shown in Fig. 3b or it may be a slanted surface part (similar to Fig. 6a).

Fig. 4a, b show an embodiment with a two-dimensional array of getter material elements 41.1, ..., 41.8, ..., 41.25, ..., 41.32, ..., 41.40. In the schematic representation there are five identical rows of getter material elements 41.1, ..., 41.8 / 41.9, ..., 41.16 etc. Each row has eight rectangular getter material elements 41.1, ...., 41.40. The periometer of the group of getter material elements 41.1, ..., 41.40 is a rectangle and defindes a total flat surface area Wtot x Btot (see diagonal hatching in Fig. 4a).

It is also possible to provide one single getter material element with a top surface that varies in x and y direction. That is, the top surface of the getter material element may be provided with a grid of trenches in x and y direction.

In a simplified embodiment, the trenches define square bumps of the getter material surface. For such a structure the requirements of the invention for the parameters depth d of the trenches and width b of the bumps and periodic length L are interrelated as follows (disregarding any fringe effects at the outskirt of the getter material):

$$\frac{4bd + L^2}{L^2} \geq 1.2$$

Again, the formula is based on the requirement of the invention that the ratio between the exposure surface area and a flat area delimited by the group perimeter is at least 120%. The formula can be transformed into:

$$\left(\frac{b}{L}\right)\left(\frac{d}{L}\right) \geq 0.05$$

The allowed parameter space according to the invention is illustrated in Fig. 10b (hatched area). If the relative thickness d/L = 0.1 and the relative width b/L= 0.8 and the periodic length is 10 micron the relative increase of the surface of the getter material element is roughly 32% (not taking into account fringe effects at the outskirt of the getter material element).

Fig. 5a, b illustrate the definition of the ratio between the exposure surface area and a flat area delimited by the group perimeter. In the present example the getter material elements are provided in two groups: The first group is in a first support surface area 50.1 as a one-dimensional array of getter elements 51.1, 51.2, 51.3 and the second group is provided in a second support surface area 50.2 as a two-dimensional array of getter elements 51.4, ..., 51.n. In each of the support surface areas 50.1, 50.2 the getter material elements have small distances to each other. However, the two support surface areas 50.1, 50.2 may have a large distance E to each other. The surface area between the groups is not relevant for the invention. This part of the surface may be used for other purposes.

As illustrated in Fig. 5a, the perimeter of the group of getter material elements does not have to be a rectangle. The first group of getter material elements 50.1, ..., 50.3 covers an area 50.1 having the shape of a polygon that has two parallel sides. The second group of getter material elements 50.4, ..., 50.n covers an L-shaped area 50.2. As shown in Fig. 5a, the perimeter of a group is typically a polygonal line that encloses the getter material elements of interest as closely as possible but that does not go into the gaps between the getter material elements of the group. The perimeter may be a convex curve (see area 50.1). However, as shown in Fig. 5a the perimeter may also have concave parts (see area 50.2).

Theoretically, the getter material elements 51.4, ..., 51.n may be separated into two subareas of getter material elements, e.g. the area for the elements 51.4, ..., 51.13 and the area for the elements 51.14, ..., 51.n. This is, however, not relevant for the invention. Both subareas comprise groups of getter material elements that are arranged in the same way with respect to increasing the getter efficiency. It is to be noted that the invention is used whenever there is a support surface area with a group of at least one getter material element, wherein the group has a perimeter defining an increased efficiency according to the invention, i.e. a ratio of 120% or more.

Fig. 6a-d show a number of variations to achieve the goal of the invention.

According to Fig. 6a the getter material elements 61 may have a flat top face 61.1 and slanted side faces 61.2, 61.3. So, a part of the exposure surface of the getter material element is inclined with respect to the support surface, on which the element is seated. The so-called total exposure surface 61.4. is schematically shown in bold line in the upper part of Fig. 6a. The exposure surface is the sum of surface area that is in contact with the free space above the support layer 60. As it is evident from Fig. 6a, the total exposure surface 61.4 may consist of a number of separate exposure areas of separate getter material elements 61. The dotted line symbolizes the flat area 61.5 defined by the perimeter of the group of individual getter material elements.

According to a specific example, the extension in x-direction may be 1 - 5 times the thickness (in z-direction). The cross-section in y-direction may be the same as in x-direction. However, it is also possible to use a shape that is different in y-direction from that in x-direction.

Fig. 6b shows a getter material element 62 has a number of bumps or peaks 63 with v-shaped grooves 64 between them. The thickness of the getter material element varies periodically between a maximum (at the spot of a bump or peak 63) and a minimum (at a low spot of a v-shaped groove 64). The total exposure surface 62.1 is schematically shown in the upper part of Fig. 6b.

It is also possible to increase the exposure surface by of the getter material element by providing a trench that has the form of a fractal curve in the top plan view.

Fig. 6c shows an example for generating a fractal curve. The present embodiment uses the principle of generating a Koch curve (invented by the swedish mathematician Helge von Koch). According to Helge von Koch the perimeter of an equilateral triangle may be increased to any desired length (even to an infinite length) without increasing the enclosed area of the Koch curve above a predefined value. As shown in the upper part of Fig. 6cf the first level curve 65("_Λ_") consists of 4 sections of identical length, namely

- a horizontal section 65.1,

- an increasing section 65.2 at an angle of 60° with respect to the direction of the horizontal section 65.1,

- a decreasing section 65.3 at an angle of -60° with respect to the direction of the horizontal section 65.1,

- a horizontal section 65.4,

This first level curve 65 is transformed into a second level curve 66 by replacing each straight section 65.1, ..., 65.4 of the first level curve 65 by a down-scaled version of the first level curve. A third level curve may be constructed by replacing each straight section of the second level curve 66 by a down-scaled version of the first level curve 65. It is evident, that by increasing the level of the curve the length of the curve may be increased without increasing the distance between its two end points.

Fig. 6d shows how to use this mathematical principle of Helge Koch for increasing the exposure surface of a rectangular getter material layer 67. The getter material layer 67 may simply be separated into two or more (e.g. 4) getter material elements 67.1, ..., 67.4, by inserting trenches 68.1, ..., 68.3 that have the shape of a Koch curve (e.g. of a second level curve or a higher level curve).

Instead of a Koch curve any other fractal curve may be used. While in Fig. 6d all four fractal curves are identical, they may also be different from each other. Furthermore, instead using several curves that are parallel shifted with respect to each other, they may also intersect each other.

Fig. 7a shows an embodiment where the surface 70.1 of the support 70 for the getter material (i.e. the top surface of the support element) is not flat but has several recesses 72.1, 72.2, 72.3. The array of getter material elements 71, which is represented by the dots on the support surface in Fig. 7, covers the recesses 72.1, ..., 72.3 as well as the area between the recesses 72.1, ..., 72.3. The single getter material elements 71 are small compared to the extension of the getter material group along the support surface 70.

While Fig. 7a gives the impression that the trenches between the getter material elements are somewhat inclined with respect to the vertical line (z-axis), it is to be stressed that in reality the tranches are vertical even on the inclined walls of the recesses 72.1, 72.2, 72.3. The vertical orientation of the trenches between the getter material elements is due to evaporation deposition method that is used.

Fig. 7b shows an embodiment where the support element has recesses as shown in Fig. 7a. However, the getter material element 73 is deposited as one continuous layer 7 that has a top surface structure as shown e.g. in Fig. 2a, b or Fig. 3a, b. The exposure surface can, therefore, also be increased by deposing the getter material on an oblique surface of the support element. The oblique surface may be obtained for instance by wet chemical etching along the natural silicon crystal orientation.

Fig. 8a, b schematically represent the method for manufacturing the getter material elements according to the invention. In a first step, a continuous getter material layer 81 is deposited on the substrate 80. This step may comprise the well known method of chemical vapour deposition (PVD). In a second step, trenches 82.1, ..., 82.5 are etched into the continuous getter material layer 81. If the trenches 82.1, ..., 82.5 extend down to the support surface 80.1, the layer 81 is separated into a number of individual getter material elements 81.1, ..., 81.6.

Fig. 9a, b illustrate the production of a getter material element 83 with a number of trenches. First, a continuous getter material layer is deposited. Then, a number of trenches 84 is etched into the getter material layer. Because the trenches 84 do not extend down to the support surface, the getter material layer 83 remains continuous but has a number of trenches in the top surface.

The embodiments shown in the figures may be varied in many ways. When there is shown a rectangular cross-section for the getter material elements, there may by a triangular, a polygonal or a rounded shape. The getter material elements may even have an irregular shape.

Instead of providing rectangular bumps as shown in Fig. 4a, there may be rectangular recesses that are separated from each others by a grid of walls extending in x and y direction.

Also the support area may have any desired shape. There is no need for rectangular or polygonal forms.

In summary, the invention provides a solution for increasing the efficiency of a getter material inside a sealed space.

**Claims**

1. A device comprising:

   a) a support structure (40) with a support area (40.1),
   b) a group of elements of at least one getter material (41.1, ..., 41.40) provided on said support area (40.1) within a group perimeter, wherein said group of getter material elements (41.1, ..., 41.40) provides a total exposure surface for absorbing gas molecules,
   c) wherein the total exposure surface has a three-dimensional shape,
   d) **characterized in that** said group of at least one getter material elements (41.1, ..., 41.40) is a plate-like getter having trenches for increasing the effective gettering surface, the three-dimensional shape of the exposure surface being such that a ratio between the exposure surface and a flat area delimited by the group perimeter is at least 120%.

2. The device of claim 1, **characterized in that** the ratio between the exposure surface and the flat area delimited by the group perimeter is at least 150%.

3. The device of claims 1 or 2, **characterized in that** said group comprises at least two getter material elements at a mutual distance of not more than twice the maximum thickness of a first of said getter material elements.

4. The device of claim 3, **characterized in that** the getter material elements are arranged in a two-dimensional array and all have the same thickness.

5. The device of any one of claims 1 to 4, **characterized in that** at least one of the getter material elements is a layer extending in x and y direction and having a thickness that varies between a maximum value and a minimum value.

6. The device of any one of claims 1 to 5, **characterized in that** the three-dimensional shape of exposure surface of the at least one getter material element (67) comprises one or more trenches (68.1, 68.2, 68.3) that have the shape of a fractal curve.

7. The device of claim 5, **characterized in that** the thickness varies in x and in y direction periodically.

8. The device of any of claims 1 to 7, **characterized in that** the getter material elements have a thickness in the range of not more than 3 micron, preferably not more than 1,5 micron.

9. The device of any of claims 1 to 8, **characterized by** at least one getter material element having a length to thickness ratio of not more than 20, preferably not more than 10.

10. The device of any of claims 5 to 9, **characterized in that** a distance in x and y direction between a first spot with maximum thickness and a second spot with minimum thickness is not more than 5 times the maximum thickness.

11. The device of any of claims 1 to 10, **characterized in that** the support surface is flat within the perimeter of the support area.

12. The device of any of claims 1 to 11, **characterized in that** the support surface is corrugated within the perimeter of the support area.

13. The device of any of claims 5 to 12, **characterized in that** the exposure surface has trenches and protrusions, the thickness of the layer in the trenches corresponding to the minimum thickness and in the protrusions to the maximum thickness.

14. The device of any of claims 1 to 13, **characterized by** a cap structure sealed to the support structure, wherein the group of getter material elements is arranged in a sealed space between the support structure and the cap structure.

15. The device of claim 13, **characterized by** a mobile structure inside said sealed space, wherein the group of getter material elements is on the mobile structure and comprises at least two getter material elements.

16. Process for manufacturing the device according to claim 1, **characterized by** the steps:

a) providing a group of elements of at least one getter material on the support structure within a support surface area,
b) wherein said group of getter material elements is provided in such a way that the three-dimensional shape of the exposure surface is such that a ratio between the exposure surface and a flat area delimited by the group perimeter is at least 120%.

17. The process of claim 16, wherein getter material is deposited on the support surface in the form of a layer with constant thickness and wherein afterwards getter material is selectively removed to generate the three-dimensional exposure surface.

18. The process of claim 17, wherein the getter layer is removed in such a way that there are at least two separate getter material elements.

**Patentansprüche**

1. Eine Vorrichtung, umfassend:

a) eine Trägerkonstruktion (40) mit einem Trägerbereich (40.1),
b) eine Gruppe von Elementen aus mindestens einem Gettermaterial (41.1,..., 41.40) bereitgestellt auf diesem Trägerbereich (40.1),innerhalb eines Gruppenumfangs, wobei diese Gruppe von Gettermaterial - Elementen (41.1,..., 41.40) eine Gesamt-Expositionsfläche zur Absorption von Gasmolekülen bildet,
c) wobei die Gesamt- Expositionsfläche eine dreidimensionale Form hat,

d) **dadurch gekennzeichnet, dass** diese Gruppe des mindestens einen Gettermaterial - Elementes (41.1,..., 41.40) ein plättchenförmiger Getter mit Rinnen ist, um die effektive Getter-Oberfläche zu erhöhen, die dreidimensionale Form der Expositionsfläche ist in einer solchen Art ausgebildet, dass zwischen der Expositionsfläche und einem flachen Bereich, der vom Gruppenperimeter begrenzt wird, ein Verhältnis von mindestens 120% besteht.

2. Die Vorrichtung nach Anspruch 1, **dadurch gekennzeichnet, dass** das Verhältnis zwischen der Expositionsfläche und dem flachen Bereich, der vom Gruppenperimeter begrenzt wird, mindestens 150% beträgt.

3. Die Vorrichtung nach Anspruch 1 oder 2, **dadurch gekennzeichnet, dass** diese Gruppe mindestens zwei Gettermaterial- Elemente umfasst, deren Entfernung voneinander nicht mehr als das Doppelte der maximalen Dicke dieser Gettermaterial- Elemente beträgt.

4. Die Vorrichtung nach Anspruch 3, **dadurch gekennzeichnet, dass** die Gettermaterial- Elemente in einer zweidimensionalen Reihe angeordnet sind und alle dieselbe Dicke haben.

5. Die Vorrichtung nach Anspruch 1 bis 4, **dadurch gekennzeichnet, dass** mindestens eines der Gettermaterial- Elemente eine Schicht bildet, die sich in x- und y- Richtung erstreckt und eine Dicke aufweist, die zwischen einem Maximal- und einem Minimalwert schwankt.

6. Die Vorrichtung nach irgendeinem der Ansprüche 1 bis 5, **dadurch gekennzeichnet, dass** die dreidimensionale Form der Expositionsfläche des mindestens einen Gettermaterial- Elementes (67) eine oder mehrere Rinnen (68.1, 68.2, 68.3) umfasst, die die Form einer fraktalen Kurve haben.

7. Die Vorrichtung nach Anspruch 5, **dadurch gekennzeichnet, dass** die Dicke in x- und y- Richtung periodisch schwankt.

8. Die Vorrichtung nach Anspruch 1 bis 7, **dadurch gekennzeichnet, dass** das Gettermaterial- Element eine Dicke im Bereich von nicht mehr als 3 Mikron hat, besser noch von nicht mehr als 1,5 Mikron.

9. Die Vorrichtung nach Anspruch 1 bis 8, **dadurch gekennzeichnet, dass** mindestens eins der Gettermaterial- Elemente ein Länge zu Dicke- Verhältnis von nicht mehr als 20 Mikron, besser noch von nicht mehr als 10 aufweist.

10. Die Vorrichtung nach irgendeinem der Ansprüche 5 bis 9, **dadurch gekennzeichnet, dass** eine Entfernung in x- und y - Richtung zwischen einer ersten Stelle mit maximaler Dicke und einer zweiten Stelle mit minimaler Dicke nicht mehr als das 5- Fache der maximalen Dicke beträgt.

11. Die Vorrichtung nach irgendeinem der Ansprüche 1 bis 10, **dadurch gekennzeichnet, dass** die Trägerfläche innerhalb des Umfangs des Trägerbereichs flach ist.

12. Die Vorrichtung nach irgendeinem der Ansprüche 1 bis 11, **dadurch gekennzeichnet, dass** die Trägerfläche innerhalb des Umfangs des Trägerbereichs gewellt ist.

13. Die Vorrichtung nach irgendeinem der Ansprüche 5 bis 12, **dadurch gekennzeichnet, dass** die Expositionsfläche Rillen und Auskragungen aufweist, die Dicke der Schicht in den Rillen entspricht der minimalen Dicke und die in den Auskragungen der maximalen Dicke.

14. Die Vorrichtung nach irgendeinem der Ansprüche 1 bis 13, **gekennzeichnet durch** eine Deckelstruktur, dimensioniert entsprechend der Trägerstrukur, wobei die Gruppe der Gettermaterial- Elemente in einem dichten Raum zwischen der Trägerstruktur und der Deckelstruktur angeordnet ist.

15. Die Vorrichtung nach Anspruch 13, charakterisiert durch eine bewegliche Struktur innerhalb dieses dichten Raums, wobei die Gruppe der Gettermaterial-Elemente sich auf der beweglichen Struktur befindet und mindestens zwei Gettermaterial- Elemente umfasst.

16. Verfahren zur Herstellung der Vorrichtung gemäß Anspruch 1, **gekennzeichnet durch** die Schritte:

a) Bereitstellung einer Gruppe Element des mindestens einen Gettermaterials auf der Trägerstruktur innerhalb eines Träger-Oberflächenbereichs.
b) wobei diese Gruppe Gettermaterial - Elemente in einer Art und Weise bereitgestellt wird, dass die dreidimensionale Form der Expositionsfläche in einer solchen Art ausgebildet ist, dass zwischen der Expositionsfläche und einem flachen Bereich, der vom Gruppenperimeter begrenzt wird, ein Verhältnis von mindestens 120% besteht.

17. Verfahren zur Herstellung der Vorrichtung gemäß Anspruch 16, wobei das Gettermaterial auf einer Trägerfläche in Form einer Schicht mit konstanter Dicke abgelagert wird und wobei danach das Gettermaterial selektiv entfernt wird, um die dreidimensionale Expositionsfläche zu erzeugen.

18. Verfahren nach Anspruch 17, wobei die Getter-Schicht in einer Art und Weise entfernt wird, das mindestens zwei getrennte Gettermaterial- Elemente vorhanden sind.

**Revendications**

1. Dispositif comprenant :

   a) une structure de support (40) comportant une zone de support (40.1),
   b) un groupe d'éléments d'au moins un matériau getter (41.1, ..., 41.40) fourni sur ladite zone de support (40.1) à l'intérieur d'un périmètre de groupe, dans lequel ledit groupe d'éléments de matériau getter (41.1, ..., 41.40) fournit une surface d'exposition totale pour absorber les molécules de gaz,
   c) dans lequel la surface d'exposition totale a une forme tridimensionnelle,
   d) **caractérisé en ce que** ledit groupe d'éléments d'au moins un matériau getter (41.1, ..., 41.40) est un getter en forme de plaque comportant des tranchées pour augmenter la surface absorbante efficace, la forme tridimensionnelle de la surface d'exposition étant telle qu'un rapport entre la surface d'exposition et une zone plane délimitée par le périmètre de groupe est d'au moins 120 %.

2. Dispositif selon la revendication 1, **caractérisé en ce que** le rapport entre la surface d'exposition et la zone plane délimitée par le périmètre de groupe est d'au moins 150 %.

3. Dispositif selon les revendications 1 ou 2, **caractérisé en ce que** ledit groupe comprend au moins deux éléments de matériau getter à une distance mutuelle ne dépassant pas deux fois l'épaisseur maximale d'un premier desdits éléments de matériau getter.

4. Dispositif selon la revendication 3, **caractérisé en ce que** les éléments de matériau getter sont agencés dans un réseau bidimensionnel et ont tous la même épaisseur.

5. Dispositif selon l'une quelconque des revendications 1 à 4, **caractérisé en ce qu'**au moins l'un des éléments de matériau getter est une couche s'étendant dans la direction x et y et ayant une épaisseur qui varie entre une valeur maximale et une valeur minimale.

6. Dispositif selon l'une quelconque des revendications 1 à 5, **caractérisé en ce que** la forme tridimensionnelle de la surface d'exposition de l'au moins un élément de matériau getter (67) comprend une ou plusieurs tranchées (68.1, 68.2, 68.3) qui ont la forme d'une courbe fractale.

7. Dispositif selon la revendication 5, **caractérisé en ce que** l'épaisseur varie dans la direction x et dans la direction y périodiquement.

8. Dispositif selon l'une quelconque des revendications 1 à 7, **caractérisé en ce que** les éléments de matériau getter ont une épaisseur dans la plage de pas plus de 3 microns, de préférence pas plus de 1,5 micron.

9. Dispositif selon l'une quelconque des revendications 1 à 8, **caractérisé par** au moins un élément de matériau getter ayant un rapport longueur/épaisseur de pas plus de 20, de préférence pas plus de 10.

10. Dispositif selon l'une quelconque des revendications 5 à 9, **caractérisé en ce qu'**une distance dans la direction x et y entre un premier point ayant une épaisseur maximale et un second point ayant une épaisseur minimale n'est pas plus de 5 fois l'épaisseur maximale.

11. Dispositif selon l'une quelconque des revendications 1 à 10, **caractérisé en ce que** la surface de support est plane à l'intérieur du périmètre de la zone de support.

12. Dispositif selon l'une quelconque des revendications 1 à 11, **caractérisé en ce que** la surface de support est ondulée à l'intérieur du périmètre de la zone de support.

13. Dispositif selon l'une quelconque des revendications 5 à 12, **caractérisé en ce que** la surface d'exposition comporte des tranchées et des saillies, l'épaisseur de la couche dans les tranchées correspondant à l'épaisseur minimale et dans les saillies à l'épaisseur maximale.

14. Dispositif selon l'une quelconque des revendications 1 à 13, **caractérisé par** une structure de couverture scellée à la structure de support, dans lequel le groupe d'éléments de matériau getter est agencé dans un espace scellé entre la structure de support et la structure de couverture.

15. Dispositif selon la revendication 13, **caractérisé par** une structure mobile à l'intérieur dudit espace scellé, dans lequel le groupe d'éléments de matériau getter est sur la structure mobile et comprend au moins deux éléments de matériau getter.

**16.** Procédé de fabrication du dispositif selon la revendication 1, **caractérisé par** les étapes :

a) fourniture d'un groupe d'éléments d'au moins un matériau getter sur la structure de support à l'intérieur d'une zone de surface de support,
b) dans lequel ledit groupe d'éléments de matériau getter est fourni d'une manière telle que la forme tridimensionnelle de la surface d'exposition est telle qu'un rapport entre la surface d'exposition et une zone plane délimitée par le périmètre de groupe est d'au moins 120 %.

**17.** Procédé selon la revendication 16, dans lequel le matériau getter est déposé sur la surface de support sous la forme d'une couche ayant une épaisseur constante et dans lequel le matériau getter est ensuite sélectivement retiré pour générer la surface d'exposition tridimensionnelle.

**18.** Procédé selon la revendication 17, dans lequel la couche de getter est retirée d'une manière telle qu'il existe au moins deux éléments de matériau getter distincts.

**Fig. 1a**

**Fig. 1b**

**Fig. 2a**   **Fig. 2b**   **Fig. 3a**   **Fig. 3b**

**Fig. 2c**   **Fig. 3c**

**Fig. 4a**   **Fig. 4b**   **Fig. 5a**   **Fig. 5b**

Fig. 6a    Fig. 6b    Fig. 6c    Fig. 6d

Fig. 7a      Fig. 7b

Fig. 8a      Fig. 9a

Fig. 8b      Fig. 9b

Fig. 10a

Fig. 10b

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6929974 B1
- US 6979974 B1
- US 20100025845 A1
- EP 1412550 B1

- US 2013089955 A1
- US 2007262428 A1
- US 2004061207 A1
- EP 2546187 A1